Europäisches Patentamt

European Patent Office

Office européen des brevets

(19)

(11) **EP 0 899 359 B1**

(12) **FASCICULE DE BREVET EUROPEEN**

(45) Date de publication et mention
de la délivrance du brevet:
**12.06.2002 Bulletin 2002/24**

(51) Int Cl.⁷: **C23C 16/34**, C23C 16/44

(21) Numéro de dépôt: **98402128.7**

(22) Date de dépôt: **27.08.1998**

(54) **Procédé de préparation par dépôt chimique en phase vapeur (CVD) d'un revêtement multicouche à base de Ti-Al-N.**

CVD-Verfahren zum Herstellen einer mehrlagigen Beschichtung auf Ti-Al-N Basis

CVD process for producing a multi-layer coating based on Ti-Al-N

(84) Etats contractants désignés:
**AT DE FR GB IT**

(30) Priorité: **29.08.1997 FR 9710801**

(43) Date de publication de la demande:
**03.03.1999 Bulletin 1999/09**

(73) Titulaire: **COMMISSARIAT A L'ENERGIE ATOMIQUE**
**75015 Paris (FR)**

(72) Inventeurs:
• **Anderbouhr, Stéphanie**
**38000 Grenoble (FR)**
• **Schuster, Frédéric**
**38000 Lans en Vercors (FR)**
• **Blanquet, Elisabeth**
**38640 Claix (FR)**

• **Theret, Gérald**
**38000 Grenoble (FR)**

(74) Mandataire: **Dubois-Chabert, Guy et al**
**BREVATOME**
**3, rue du Docteur Lanceraux**
**75008 Paris (FR)**

(56) Documents cités:
**EP-A- 0 117 542          EP-A- 0 709 483**
**WO-A-90/11858          DE-A- 4 408 250**

• **SANG-HYEOB LEE ET AL: "COMPOSITIONALLY GRADIENT (TI1-XALX)N COATINGS MADE BY PLASMA ENHANCED CHEMICAL VAPOR DEPOSITION" JOURNAL OF VACUUM SCIENCE AND TECHNOLOGY: PART A, vol. 13, no. 4, 1 juillet 1995, pages 2030-2034, XP000540937**

**Description**

La présente invention concerne un procédé de préparation par dépôt chimique en phase vapeur (encore appelé CVD : Chemical Vapour Deposition) d'un revêtement multicouche à base de Ti-Al-N, c'est-à-dire un revêtement multicouche de TiN et $Ti_{1-x}Al_xN$ dans lequel, par exemple, les couches de $Ti_{1-x}Al_xN$ peuvent avoir des compositions variables.

L'invention a également trait au revêtement préparé par ce procédé.

Plus précisément, l'invention est relative à un procédé procédé de préparation d'un revêtement multicouche, comprenant un empilement sur un substrat de plusieurs couches choisies parmi les couches constituées de TiN et les couches constituées de (Ti,Al)N encore appelé $Ti_{1-x}Al_xN$, l'ensemble du revêtement étant réalisé, en une seule opération continue, par dépôt chimique en phase vapeur thermique (CVD) à partir d'un mélange gazeux comprenant un gaz réducteur tel que l'ammoniac ou l'azote de l'hydrogène et des chlorures de titane et éventuellement d'aluminium, la nature et/ou la composition de chaque couche déposée étant ajustée(s) instantanément en modifiant le rapport molaire gaz réducteur sur hydrogène dans le mélange gazeux.

Le domaine technique de l'invention peut être généralement défini comme celui du dépôt de couches minces sur des substrats en vue d'améliorer les propriétés de ces derniers.

Les céramiques de type nitrure ont trouvé depuis longtemps de nombreuses applications industrielles en particulier du fait de leurs excellentes résistances à la corrosion et à l'usure.

Parmi ces céramiques de type nitrure, le nitrure de titane (TiN) est particulièrement intéressant du fait de ses caractéristiques mécaniques attractives, à savoir un faible coefficient de frottement, une bonne résistance à l'usure, et une dureté élevée représentée par une dureté Knoop (Hardness Knoop en anglais) d'environ 1400.

Le nitrure de titane est donc utilisé depuis longtemps pour le revêtement en surface de substrats, en particulier d'outils de coupe, notamment d'outils de coupe en acier opérant à grande vitesse, afin d'augmenter leur résistance à l'usure.

Toutefois, les dépôts de nitrure de titane présentent l'inconvénient majeur de s'oxyder, par exemple à l'air ambiant, à partir de 673 K, ce qui exclut l'utilisation de tels dépôts à haute température.

De nombreuses recherches se sont portées sur des nitrures de titane plus complexes, il s'est avéré que l'insertion d'aluminium dans le réseau cubique du nitrure de titane TiN amenait un accroissement sensible de la résistance à l'oxydation. En effet, il se formerait à la surface du nitrure de titane aluminium encore dénommé (Ti,Al)N ou $Ti_{1-x}Al_xN$, une couche mince protectrice d'alumine amorphe qui préserverait le revêtement dur de toute oxydation supplémentaire et augmenterait ainsi la durée d'utilisation de l'outil revêtu.

Il a été mis en évidence qu'un tel résultat n'est pas observé lors de dépôts mixtes de TiN et d'AlN.

Pour ce qui concerne les procédés d'élaboration, les procédés utilisés pour le dépôts de couches de TiN, sont essentiellement des procédés de dépôt physique en phase vapeur (PVD ou Physical Vapour Deposition en anglais) tels que les pulvérisations réactives ou l'évaporation cathodique par arc.

La technique de dépôt physique en phase vapeur PVD est particulièrement bien adaptée au dépôt du nitrure de titane, sur des substrats tels que des outils en. acier, car la température de traitement ne doit pas excéder 750°C, température au-dessus de laquelle se produit généralement la transformation de phase de l'acier.

Des couches minces de TiN ont été plus récemment déposées par la technique de dépôt chimique en phase vapeur CVD (Chemical Vapour Deposition en anglais) en utilisant des précurseurs de type chlorure métallique qui sont décomposés à température élevée, on désigne généralement ce procédé sous le terme de CVD thermique ou LPCVD (Low Pressure CVD) lorsqu'on opère à basse pression.

Une autre technique' de dépôt chimique en phase vapeur (CVD) de films de nitrure de titane est la technique dite de dépôt chimique en phase vapeur de composés organométalliques réalisée généralement à basse pression, qui est dénommée OMCVD (Organo Metallic Chemical Vapour Deposition en anglais) ou encore LPOMCVD (Low-Pressure Organo Metallic Chemical Vapour Déposition en anglais).

L'utilisation de précurseurs organométalliques au lieu des précurseurs de type chlorures métalliques utilisés dans les procédés de dépôt chimique en phase vapeur classiques, dits procédés de CVD « thermique » permet de réduire notablement la température de réaction, qui passe par exemple de 873 K avec les chlorures, à 673 K et même à 473 K avec des composés organométalliques.

Ainsi, le document de C. JIMENEZ, S. Gilles, C. BERNARD et R. MADAR « Deposition of TiN Thin Films by Organometallic Chemical Vapour Deposition : Thermodynamical Predictions and Experimental Results », Surface and Coatings Technology, 76-77 (1995) 237-243, décrit-il le dépôt à basse pression de films de nitrure de titane pur à partir de tetrakis-diméthylamino-titane ($Ti(N(CH_3)_2)_4$) en tant que précurseur et de $NH_3$.

Des couches de TiN ont également été déposées par la technique de dépôt chimique en phase vapeur assisté par plasma PACVD (Plasma Assisted Chemical Vapour Deposition en anglais) ou PECVD (Plasma Enhanced Chemical Vapour Deposition en anglais), qui permet également un traitement à température relativement faible. Mais une telle technique est également difficile à mettre en oeuvre et ne permet pas le revêtement de pièces aux géométries complexes.

De même, les revêtements de (Ti,Al)N ou $Ti_{1-x}Al_xN$ sont, pour la plupart, préparés par les procédés de dépôt physique en phase vapeur (PVD) déjà mentionnés plus haut dans le cadre de la préparation des revêtement de TiN. Ces procédés présentent certains inconvénients, liés essentiellement à la difficulté de revêtir uniformément des substrats et pièces de formes complexes, et à la complexité de la mise en oeuvre et de la préparation des cibles de PVD.

On a donc cherché à préparer des revêtements de (Ti,Al)N ou $Ti_{1-x}Al_xN$ par des procédés de dépôt chimique en phase vapeur (CVD ou Chemical Vapour Deposition en anglais) tels que des procédés dits de CVD thermique, des procédé de PACVD ou encore des procédés de OMCVD, qui présentent l'avantage de permettre le revêtement uniforme de pièces de 'géométries complexes ainsi qu'un meilleur contrôle de la stoechiométrie des couches.

Ainsi, le document S.H. LEE, H.J. RYOO et J.J. LEE, J. Vac. Sci. Technol. A12(4) (1994), 1602 est-il relatif à la préparation de revêtements monocouches de $Ti_{1-x}Al_xN$ de composition fixe par la technique de PACVD en utilisant un mélange gazeux de $TiCl_4$, d'$AlCl_3$, de $NH_3$, d'hydrogène et d'argon.

Le document de K.H. Kim et S.H. Lee, Thin Solid Films, 283 (1996), 165-170 décrit la préparation de revêtements monocouches de $Ti_{1-x}Al_xN$ de composition fixe sur des substrats en acier et en silicium par la technique PACVD en utilisant un mélange gazeux analogue à celui du document précédent mais dans lequel l'ammoniac est remplacé par de l'azote.

Le document de S. GILLES, N. BOURHILA, S. IKEDA, C. BERNARD et R. MADAR ICMCTF, mai 1997, Conference ICMCTF, San Diego, décrit le dépôt de monocouches minces de nitrure de titane aluminium (Ti,Al)N ou $Ti_{1-x}Al_xN$ par dépôt chimique en phase vapeur utilisant des précurseurs organométalliques (OMCVD) à partir d'un gaz contenant de l'ammoniac, et en tant que précurseurs métalliques du tétrakis diméthylamino titane $Ti(N(CH_3)_2)_4$ et de l'hexakis diméthylamido dialuminium $Al_2(N(CH_3)_2)_6$.

Il est indiqué que la variation du débit d'ammoniac peut entraîner une augmentation de la proportion d'aluminium dans le nitrure de titane aluminium déposé, mais ce document ne décrit que la préparation de revêtements monocouches de composition définie.

Aucun des documents cités ci-dessus ne mentionne ni n'évoque la préparation de revêtements formés d'un empilement multicouche de TiN et/ou (Ti,Al)N.

Il est cependant connu que des revêtements multicouches comprenant un empilement de couches de TiN et/ou de (Ti,Al)N peuvent être réalisés mais uniquement par la technique de dépôt physique en phase vapeur (PVD).

C'est notamment le cas du revêtement multicouche anti-usure commercialisé sous la dénomination « BALINIT FUTURA » par la société BALZERS®, dont l'application principale reste le domaine de l'outillage.

Outre les défauts déjà indiqués plus haut dans le cas du dépôt de revêtements à une seule couche, et inhérents au procédé de dépôt physique en phase vapeur (PVD), la mise en oeuvre de ce procédé PVD pour la préparation d'un revêtement multicouche présente de plus l'inconvénient d'une grande rigidité, puisque les cibles de PVD ont une composition fixée.

Il n'est donc pas possible en une seule opération de déposer plusieurs couches de nature différente (AlN et (Al,Ti)N car il est nécessaire de changer chaque fois la cible et de stopper le procédé pour effectuer le dépôt d'une autre couché, et/ou de déplacer le substrat d'une enceinte de dépôt vers une autre enceinte de dépôt, de ce fait la complexité et le volume des installations s'en trouve accru et le temps nécessaire au dépôt du revêtement multicouche fortement augmenté.

Le dépôt par PVD ne peut permettre par exemple que le dépôt d'une revêtement ayant une alternance de couches de. TiN et de (Ti,Al)N, les couches de (Ti,Al)N ayant chaque fois la même composition, c'est-à-dire la même proportion en aluminium, il n'est en effet pas possible de faire varier la proportion en aluminium d'une couche' en (Al, Ti,)N à l'autre car cela entraînerait chaque fois la préparation et l'installation d'une cible différente.

Du fait du peu de souplesse et de flexibilité d'un tel procédé, les applications demeurent très limitées car une installation ne peut servir que dans le cadre du dépôt d'un revêtement bien précis et nécessite de longues et coûteuses opérations d'adaptation et de modification pour pouvoir être utilisé pour le dépôt d'un autre revêtement qui diffère par la nature et/ou la composition d'une couche.

Il existe donc un besoin non encore satisfait pour un procédé de préparation d'un revêtement multicouche comprenant un empilement de plusieurs couches choisies parmi les couches constituées de TiN et de $Ti_{1-x}Al_xN$, qui soit, entre autres, facile à mettre en oeuvre, nécessite un nombre réduit d'opérations, qui soit d'une grande souplesse d'utilisation, qui permette de préparer avec des opérations d'adaptation réduites, une grande variété de revêtements différant par la nature, et/ou la composition, et/ou la succession des couches déposées et enfin qui donne des revêtements présentant d'excellentes propriétés mécaniques et de résistance à la corrosion, et ayant des compositions parfaitement définies.

Ce procédé doit également ' permettre un revêtement uniforme, d'épaisseur maîtrisée quelle que soit'la géométrie du substrat.

Le but de l'invention est donc de fournir un procédé de préparation d'un revêtement multicouche comprenant un empilement sur un substrat de plusieurs couches choisies parmi les couches constituées de TiN et de $Ti_{1-x}Al_xN$ (ou

(Ti,Al)N), qui ne présente pas les défauts, les inconvénients et. les limitations des procédés de l'art antérieur, qui apporte une solution aux problèmes posés par les procédés de l'art antérieur, et qui réponde entre autres aux besoins mentionnés plus haut.

Ce but, et d'autres encore sont atteints conformément à l'invention par un procédé de préparation d'un revêtement multicouche, comprenant un empilement sur un substrat de plusieurs couches choisies parmi les couches constituées de nitrure de titane TiN et les couches constituées de nitrure de titane aluminium $Ti_{1-x}Al_xN$ (ou (Ti,Al)N), caractérisé en ce que ledit revêtement est déposé en continu et en une seule opération par dépôt chimique en phase vapeur thermique (CVD, thermique) à partir d'un mélange gazeux réducteur comprenant de l'ammoniac, de l'hydrogène, et en tant que précurseurs, des chlorures de titane et éventuellement d'aluminium, préparés in-situ par chloruration d'une charge ou cible unique d'alliage de titane et d'aluminium, la nature et/ou la composition de chaque couche déposée étant ajustée(s) instantanément au cours de l'opération de dépôt en modifiant le rapport molaire gaz réducteur sur hydrogène dans le mélange gazeux.

Le procédé de dépôt selon l'invention, est simple, facile à mettre en oeuvre, et d'une grande souplesse et flexibilité. Le procédé selon l'invention par CVD thermique s'affranchit totalement des inconvénients du procédé par PVD.

Le dépôt d'un revêtement multicouche même très complexe qui peut présenter une succession complexe d'un très grand nombre de couches de nature et/ou de composition différentes est possible selon l'invention par dépôt chimique en phase vapeur en une seule opération réalisée en continu, sans arrêt, sans procéder à une changement de charge (cible) et/ou à un transfert du substrat revêtu d'une enceinte vers une autre enceinte, ce qui est le cas des procédés connus mettant en oeuvre la technique de PVD.

Selon l'invention, au contraire des procédés par PVD, il est possible au cours du processus de dépôt par CVD, sans avoir recours à aucune opèràtion d'adaptation lourde et compliquée, et sans arrêt de ce processus, d'ajuster instantanément, à volonté, et en permanence, la nature et/ou la composition de chaque couche déposée en agissant simplement sur le rapport molaire gaz réducteur sur hydrogène dans le mélange gazeux, en conservant par ailleurs une source unique d'alliage de titane et d'aluminium tout au long de l'opération de dépôt.

Selon l'invention, il est donc possible en' agissant simplement sur le rapport molaire gaz réducteur sur hydrogène, c'est-à-dire encore sur la quantité molaire de gaz réducteur et notamment sur le débit de celui-ci, de modifier et de choisir la nature de chaque couche déposée, sans arrêter l'opération de dépôt, c'est-à-dire que l'on peut faire en sorte que la couche déposée soit du TiN pur ou du (Ti,Al)N sans qu'il soit nécessaire de changer la cible ou charge.

Le gaz réducteur est généralement de l'ammoniac ou de l'azote.

Le rapport molaire gaz réducteur sur hydrogène dans le mélange gazeux est généralement de 0,01 à 1.

On peut également choisir de manière précise, en ajustant le rapport molaire gaz réducteur sur hydrogène ou la quantité de gaz réducteur, la composition de chaque couche de (Ti,Al)N ou $Ti_{1-x}Al_xN$ dans toute la gamme des valeurs possibles pour la proportion d'aluminium définie par la valeur x, la cible restant la même que pour le dépôt des couches de TiN.

A titre d'exemple, la proportion d'aluminium dans le nitrure de titane aluminium peut varier de 0 à 60 %.

De même, on peut faire en sorte que toutes les couches de (Ti,Al)N aient la même composition (même rapport $\frac{Ti}{Al}$), ou bien ou peut choisir qu'une ou plusieurs parmi ces couches, lorsque le revêtement en comporte deux ou plus, aient des compositions différentes les unes des autres, cela peut être réalisé immédiatement en modifiant simplement le rapport molaire gaz réducteur sur hydrogène ou la quantité de gaz réducteur.

Selon un aspect particulièrement avantageux de l'invention, il est possible en outre, en cours de dépôt, de modifier la composition de chaque couche de $Ti_{1-x}Al_xN$ déposée afin d'obtenir par exemple une couche à gradient de composition dont la composition varie généralement de manière progressive et continue tout au long de son épaisseur, depuis une composition correspondant par exemple à une couche de TiN pur jusqu'à une couche à très forte teneur en aluminium (dont la valeur de x est très élevée par exemple égale à 0,6).

Grâce au procédé selon l'invention, la composition et la nature de chaque couche peut être maîtrisée avec une grande précision. Il en résulte que les revêtements préparés présentent également des propriétés parfaitement maîtrisées.

Le procédé selon l'invention; peut être facilement adapté à la préparation d'un revêtement particulier pour une application particulière, et il permet donc de préparer toutes sortes de revêtements possédant des propriétés physico-chimique et mécaniques très variées convenant pour une large gamme d'applications qui n'étaient pas jusqu'à présent envisagées pour des revêtement de ce type.

Le procédé selon l'invention élargit ainsi considérablement le champ des applications potentielles des revêtements multicouches de nitrure de titane et de nitrure de titane aluminium.

Le procédé selon l'invention permet aussi de préparer les revêtements multicouches suivants :

Il s'agit, d'autre part, des revêtements multicouches qui comprennent un empilement de plusieurs couches choisies parmi les couches constituées de TiN et de $Ti_{1-x}Al_xN$ (ou (Ti,Al)N) et qui comprennent au moins deux couches de $Ti_{1-x}Al_xN$, au moins un de ces couches de $Ti_{1-x}Al_xN$ ayant une composition différente de l'autre ou des autre(s)

couche(s) de $Ti_{1-x}Al_xN$.

De préférence, dans ce cas, au moins une de ces couches de $Ti_{1-x}Al_xN$ est une couche à gradient de composition.

De préférence, les couches de TiN et de $Ti_{1-x}Al_xN$ sont alternées mais le revêtement peut également comprendre un empilement de couches constituées uniquement de $Ti_{1-x}Al_xN$, chaque couche ayant une composition différente (de la couche précédente et de la couche suivante), ou les couches ayant par exemple deux à deux des compositions analogues, c'est-à-dire que les couches « impaires » ont une composition définie et les couches « paires » ont une autre composition définie.

D'autres caractéristiques et avantages de l'invention apparaîtront mieux à la lecture de la description qui suit, donnée à titre illustratif, mais non limitatif, en références aux figures annexées sur lesquelles :

- la figure 1 représente une vue en coupe schématique d'un exemple d'un dispositif permettant l'élaboration des revêtements multicouches selon l'invention.
- la figure 2 représente un exemple (exemple 6) d'une séquence de réalisation d'un dépôt multicouche TiN, (Ti,Al)N sous la forme d'un graphique où est porté en abscisses le temps exprimé en minutes et en ordonnées le rapport molaire $NH_3/H_2$ dans le mélange gazeux.

Le procédé selon l'invention comprend plus précisément, par exemple, la succession d'étapes suivantes, qui sont des étapes classiques dans les procédés de CVD thermique pour le dépôt d'une couche de revêtement :

<u>La première étape</u> consiste à former « in situ » des chlorures métalliques de titane et d'aluminium en partant d'une charge, dans le cas du procédé selon l'invention d'une charge unique, d'alliage de titane et d'aluminium.

L'alliage de titane et d'aluminium mis en oeuvre est de préférence un alliage du type Ti-Al sous forme solide mais d'autres alliages tels que les alliages $TiAl_2$, $TiAl_3$ peuvent également convenir.

L'alliage de titane et d'aluminium est généralement utilisé sous la forme de barreaux ou copeaux car une telle forme favorise la chloruration.

L'opération de chloruration est généralement réalisée en utilisant du chlore gazeux, de préférence dilué avec un gaz diluant un gaz vecteur tel que de l'argon dans une proportion $Cl_2/Ar$ = 1/2 par exemple.

L'alliage de titane et d'aluminium est de préférence porté à une température de 973 à 1173 K et la chloruration est généralement effectuée à une pression de $10^2$ à $10^5$ Pa.

La quantité de $Cl_2$ est de préférence choisie pour obtenir une chloruration totale de l'alliage, ainsi dans le cas d'un alliage TiAl, le métal est généralement en excès par rapport au chlore.

Par exemple, pour une quantité de métal de 10 moles, la quantité de chlore est de préférence de 1 mole, la phase 'gazeuse' est alors principalement composée des espèces $AlCl_3$ et $TiCl_3$, lorsqu'on se place de préférence à une température de 1023 K et à une pression de 1130 Pa, et la quantité molaire de $AlCl_3$ produit est de cinq à dix fois supérieure à la quantité de $TiCl_3$.

<u>La deuxième étape</u> consiste à mélanger les produits gazeux issus de la chloruration avec le gaz réducteur, l'hydrogène et éventuellement un gaz vecteur ou porteur choisi parmi l'argon, l'hélium et leurs mélanges.

Le gaz réducteur est choisi de préférence parmi l'azote, et l'ammoniac, l'ammoniac étant encore préféré. L'opération de mélange est généralement réalisée à une température de 523 K. à 773 K.

Selon l'invention, il est possible de faire varier la composition des couches déposées en agissant simplement sur le rapport molaire gaz réducteur, par exemple $NH_3$, sur hydrogène dans le mélange gazeux.

Il apparaît qu'une augmentation du rapport molaire gaz réducteur, par exemple $NH_3$, sur hydrogène, permet d'accroître la proportion d'aluminium par rapport au titane dans la couche déposée.

Dans le cas où la quantité d'hydrogène, et par voie de conséquence son débit est constant, on peut alors également se référer simplement à la quantité molaire de gaz réducteur, tel que $NH_3$, dans le mélange, dont l'augmentation accroît la proportion d'aluminium.

Si le débit de $H_2$ est constant on augmente facilement la proportion d'Al en augmentant le débit de gaz réducteur.

Le rapport molaire gaz réducteur sur hydrogène, par exemple $NH_3/H_2$, dans le mélange gazeux, peut varier par exemple de 0,01 à 1 ; par exemple, pour un rapport molaire d'environ 0,01 on prépare du TiN pur, tandis que pour des rapports molaires de 0,02 à 0,1 on prépare des nitrures de titane aluminium avec x variant de 5 à 60 par exemple.

Il semblerait, sans vouloir être lié par aucune théorie qu'une augmentation de la concentration en gaz réducteur, par exemple en $NH_3$, favorise la décomposition des chlorures d'aluminium., et par conséquent accroisse la quantité de nitrure d'aluminium déposée.

Dans le mélange gazeux, la quantité molaire de gaz réducteur, par exemple de $NH_3$, et la quantité molaire d'hydrogène, sont toutes deux généralement en excès par rapport à la quantité molaire de chlorures de titane et d'aluminium générés. Par exemple, la quantité molaire de gaz réducteur, tel que $NH_3$, est supérieure, de préférence nettement supérieure à la quantité molaire de chlorures, tandis que la quantité molaire d'hydrogène est de préférence au moins 2 fois, de préférence encore au moins 3 fois, mieux au moins 5 fois supérieure à la quantité molaire de chlorures.

Suite au mélange des produits issus de la chloruration avec le gaz réducteur, l'hydrogène et éventuellement le gaz vecteur tel que l'argon, on procède à la phase de dépôt proprement dite, par réaction des éléments présents en phase gazeuse avec la surface chaude du substrat à revêtir, selon le principe généralement mis en oeuvre dans la technique du dépôt chimique en phase vapeur thermique.

Le ou les substrat(s) qui peuvent être revêtu(s) par le procédé de l'invention sont de préférence des substrats en métaux tels que des substrats en acier par exemple en acier au carbone ou en acier inox.

Mais des substrats en d'autres matériaux tels que des substrats en silicium par exemple des substrats en silicium monocristallin de type <110> ou encore <100> peuvent également être revêtus par le procédé selon l'invention.

Le substrat peut prendre une forme quelconque, mais il de préférence constitué par des pièces usinées, finies, par exemple des pièces faisant partie d'outils de coupe, ou d'autres outils.

De même, il est possible de ne revêtir qu'une partie de la surface du substrat, une autre partie n'étant pas revêtue, ou bien revêtue d'un dépôt de nature différente.

La température à laquelle est porté le substrat est de préférence de 700 à 1400 K, de préférence encore de 873 à 1073 K, par exemple de 973 K et le dépôt est réalisé généralement à une pression de $10^2$ à $10^5$ Pa, par exemple de 1130 Pa (10 Torr).

La vitesse de dépôt dépend des paramètres du procédé et de la nature du substrat et est généralement de 0,1 à 10 μm/h, de préférence de 0,5 à 5 μm/h.

Du fait que l'ensemble du dépôt multicouche peut être réalisé en une seule opération, en continu, sans arrêt, sans changement de la cible, la durée totale du dépôt par le procédé selon l'invention, qui est par exemple de 15 minutes à 2 heures, est très nettement inférieure à la durée du dépôt d'un revêtement multicouche par PVD qui est généralement de 10 heures à plusieurs dizaines d'heures du fait des arrêts intervenant entre le dépôt de chaque couche, et sans tenir compte en outre du temps nécessaire à la préparation des cibles PVD.

Cette durée réduite du dépôt constitue l'un des avantages supplémentaires du procédé selon l'invention.

Comme on l'a déjà indiqué plus haut, la nature, la composition, la succession, et le nombre de couches déposées sont variables.

La caractéristique fondamentale du procédé et de permettre sans changer la cible, dans une même enceinte, en continu, le dépôt soit de couches de TiN pur, soit de couches de $Ti_{1-x}Al_xN$, les couches de (Ti,Al)N pouvant avoir des compositions différentes les unes des autres, les couches de (Ti,Al)N pouvant aussi présenter un gradient de composition, le gradient de composition pouvant être quelconque.

La succession des couches peut être variable c'est-à-dire que des couches de TiN peuvent par exemple alterner avec des couches de (Ti,Al)N, chacune des couches de (Ti,Al)N ayant la même composition ou une ou plusieurs des couches de (Ti,Al)N ayant une composition différentes des autres couches de (Ti,Al)N.

L'empilement des couches peut également ne comporter que des couches de (Ti,Al)N, chaque couche ayant une composition différente de la couche qui la suit et de la couche qui la précède dans l'empilement.

A titre d'exemple de revêtement, on peut citer un revêtement bicouche comprenant sur le substrat une couche de TiN, puis une couche de (Ti,Al)N dont la proportion de Al peut être quelconque, ou'un revêtement bicouche formé d'une couche de (Ti,Al)N sur le substrat, puis d'une autre couche de (Ti,Al)N de composition différente de la première.

Le nombre de couches déposées est généralement de 2 à quelques centaines, par exemple de 2 à 1000, de préférence de 10 à 500, de préférence encore de 50 à 100 ou 200.

L'épaisseur de chaque couche déposée est généralement de 0,02 à 0,5 μm.

L'épaisseur totale du revêtement est généralement de 1 à 50 μm.

Cette épaisseur dépend notamment de l'application recherchée.

Ainsi, pour des applications mécaniques, par exemple pour protéger un outil des rayures, on utilisera de préférence une épaisseur de 2 à 5 μm, tandis que pour des applications de protection contre la corrosion par les métaux liquides, on utilisera de préférence une épaisseur d'environ 10 μm.

Selon un mode de réalisation particulièrement avantageux de la présente invention, il est possible d'associer un traitement thermochimique, tel qu'une nitruration thermique ou ionique ou encore une carburation, au procédé de dépôt par CVD thermique selon l'invention.

Le traitement thermochimique et le dépôt d'un revêtement par CVD thermique peuvent être mis en oeuvre successivement dans la même installation, par exemple dans l'enceinte où est réalisée le dépôt, sans remise à l'air intermédiaire des substrats.

Le traitement thermochimique peut être réalisé préalablement au dépôt afin de conférer une excellente adhérence au revêtement et d'obtenir un meilleur comportement mécanique global par un effet durcissant de la couche, ou bien en phase finale, ce qui assure une protection supplémentaire du revêtement.

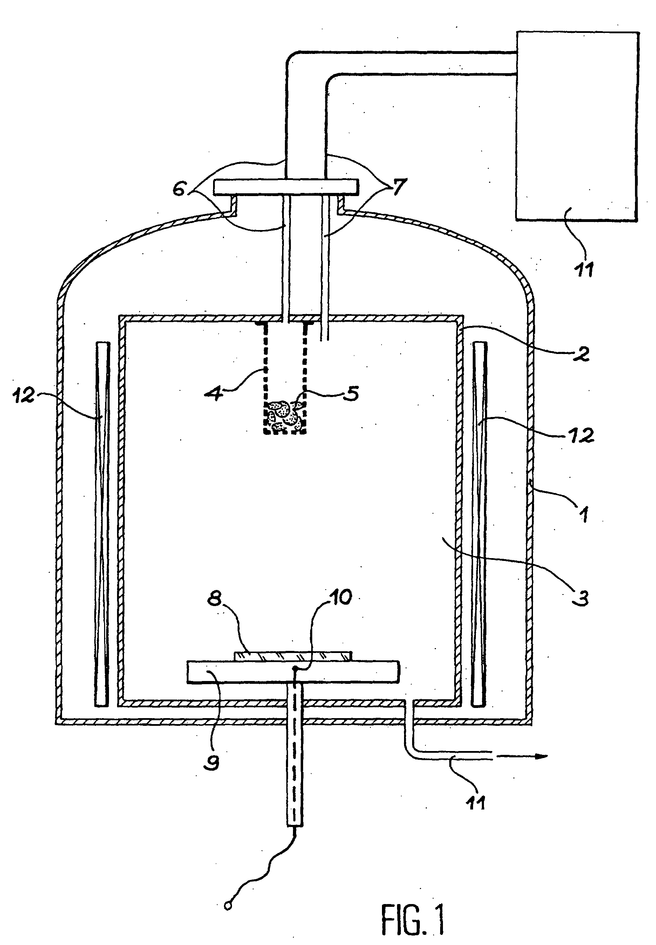

Sur la figure 1, on a représenté de manière très schématique un exemple de réacteur convenant pour la mise en oeuvre du procédé selon l'invention.

Un tel réacteur, moyennant quelques adaptations, est sensiblement analogue au réacteur décrit dans le document de N. THOMAS, P. SURYANARAYANA, E. BLANQUET, C. VAHLAS, R. MADAR et C. BERNARD, Journal of the Electrochemical Society, 240 (1993)475.

Selon la figure 1, le réacteur 1 comprend une enceinte de dépôt chimique en phase vapeur 2 comprenant une chambre de dépôt 3 permettant de traiter le ou les substrat(s) à la température voulue, et une chambre de chloruration 4 ou chambre intermédiaire dans laquelle est placée un alliage d'aluminium et de titane 5 sous forme solide, la chambre de chloruration peut par exemple prendre la forme d'un tube fermé par un fond perforé qui est alimenté en chlore par la canalisation 6.

Une zone de mélange (non représentée) est également prévue pour recevoir les produits issus de la chloruration et l'hydrogène, le gaz réducteur tel que l'ammoniac, et éventuellement un gaz porteur tel que l'argon, qui sont injectés, de préférence latéralement, par l'intermédiaire de la canalisation 7.

Dans la chambre de dépôt, le substrat 8, est placé sur un support 9 adéquate qui peut être par exemple un suscepteur dans le cas d'un chauffage par induction.

Ce support est relié à un' thermocouple 10 permettant de mesurer en permanence la température du substrat.

Un groupe de pompage sec d'un débit maximal égal par exemple à 300m$^3$/h est relié à la partie supérieure de la chambre de réaction par la canalisation 11, et permet de réaliser et de maintenir la pression voulue à l'intérieur de l'enceinte.

Le réacteur est également pourvu de moyens d'alimentation en gaz sous forme par exemple d'un « panneau de gaz » 11 équipé d'un minimum de 5 lignes, comprenant une armoire de commande munie d'un orifice de ventilation réservé aux gaz chlorés.

L'armoire de commande présente des tiroirs de commande de pompage, de débits de gaz, et de pression totale ; la mesure de la pression est fournie par une jauge capacitive, et elle est maintenue constante en pilotant le débit total des gaz.

Chaque ligne de gaz, en particulier celle de gaz réducteur tel que NH$_3$, est équipée d'un débitmètre'' massique à régulation électronique et d'une vanne d'arrêt qui sont reliés à l'armoire de commande munie de dispositifs d'affichage du débit et de réglage simultané. On peut donc agir à volonté, instantanément, au cours du procédé sur les débits gazeux, en particulier de gaz réducteur tel que NH$_3$, et par voie de conséquence sur la nature et la composition des couches déposées.

Le réacteur comprend également des moyens de chauffage et de régulation de la température permettant d'atteindre et de maintenir les températures de chloruration et de dépôt.

Dans le réacteur présenté sur la figure 1, les moyens de chauffage 12 sont des moyens résistifs et peuvent être réalisé sous la forme d'une série de résistances longeant la paroi de l'enceinte et régulées en température par un contrôle de la puissance électrique dissipée dans les résistances.

Il est bien évident que les moyens de chauffage peuvent prendre toute autre forme possible, par exemple le chauffage de la chambre de dépôt et du substrat peut être un chauffage inductif réalisé par l'intermédiaire du chauffage du substrat au moyen d'un suscepteur activé par des bobines d'induction entourant la chambre de dépôt.

Les chambres de dépôt et de chloruration peuvent être chauffées avec les mêmes moyens de chauffage ou il peut être prévu des moyens de chauffage séparés, inductifs ou résistifs, pour chauffer chacune de ces chambres.

Les revêtements selon l'invention trouvent leur application dans tous les domaines où sont mis en oeuvre des revêtements à base de nitrure de titane, par exemple dans le domaine de l'outillage, et plus particulièrement pour le (Ti,Al)N, dans des applications de protection contre l'oxydation à haute température et contre la corrosion par les métaux liquides, par exemple l'aluminium liquide et ses alliages, ou par l'uranium liquide et ses alliages tel que l'uranium-fer.

Les exemples suivants donnés à titre illustratif et non limitatif illustrent le procédé de l'invention.

Exemple 1

Cet exemple illustre des conditions permettant d'obtenir un dépôt de nitrure de titane pur sur divers substrats.

Le dispositif mis en oeuvre est sensiblement analogue à celui de la figure 1.

Les paramètres du procédé sont les suivants :

- Température de chloruration : 1023 K
- Température de dépôt : 973 K
- Pression totale : 1130 Pa (10 torr)
- Débits gazeux (cm$^3$/min) : Cl$_2$ : 5
  NH$_3$ : 3
  H2 : 340
  Ar : 640

Ar diluant le $Cl_2$ : 10

- substrats : - Acier (type 30CD4),
  - Acier inoxydable(nuance Z150CDV12),

et

  - Silicium orienté <110>.

On obtient une vitesse de dépôt de l'ordre de 0,2 à 2 µm/h suivant les substrats utilisés, c'est-à-dire 0,2 µm/h pour le substrat acier et 2 µm/h pour le Si <110>.

Le dépôt est constitué, en utilisant les conditions opératoires ci-dessus, de nitrure de titane pur.

La nature du dépôt a été déterminée par diffraction aux rayons X.

Les épaisseurs des dépôts ont été déterminées par observation au MEB (microscope électronique à balayage) de coupes métallographiques des échantillons, et ont été trouvées dans une gamme allant de 200 Å pour l'acier à 2 µm pour le silicium, dans les conditions de dépôts citées précédemment.

Exemple 2

Cet exemple illustre les conditions permettant d'obtenir un dépôt de nitrure de titane aluminium (Ti,Al)N ou $Ti_{1-x}Al_xN$ sur divers substrats. Les paramètres du procédé sont les suivants.

- Températures de chloruration : 1023 K
- Température de dépôt : 973 K
- Pression totale : 1130 Pa (10 Torr)
- Débits gazeux ($cm^3$/min) : $Cl_2$ : 5 :
  $NH_3$ : 5
  $H_2$ : 155
  Ar : 650
  Ar diluant le $Cl_2$ : 10
- substrats : analogues à ceux de l'exemple 1.

On obtient une vitesse de dépôt de l'ordre de 1 à 5 µm/h selon les substrats utilisés c'est-à-dire 1µm/h pour le substrat en acier et 5 µm/h pour le silicium.

Le dépôt est constitué, en utilisant les paramètres opératoires ci-dessus, de nitrure de titane aluminium (Ti, Al)N ou $Ti_{1-x}Al_xN$ présentant un rapport Ti/Al défini et égal à 0,48/0,52.

Les épaisseurs des dépôts sont de 1 à 5 µm suivant les types de substrats (respectivement pour l'acier et le Si).

La nature et l'épaisseur des dépôts ont été déterminées de la même manière que dans l'exemple 1, et les rapports Ti/Al ont été déterminés par une analyse effectuée par EDS (Spectrométrie à dispersion d'énergie, en anglais Energie Dispersive Spectroscopy).

Les exemples 1 et 2 mettent en évidence l'influence des différents paramètres expérimentaux, et en particulier l'influence de la quantité molaire de $NH_3$, sur la nature et la composition des couches.

Il est possible en augmentant la quantité de $NH_3$, par exemple en passant d'un débit de 3 $cm^3$/min à 5 $cm^3$/min d'obtenir un dépôt de nature différente soit de nitrure de titane, soit de nitrure de titane aluminium ce dernier étant de composition définie.

Exemples 3 à 5.

Dans ces exemples, on a de manière analogue à l'exemple 2 ci-dessus, effectué des dépôts sur des substrats en acier, acier inoxydable et silicium.

Les paramètres sont les mêmes que ceux de l'exemple 2 sauf que pour le dépôt on a utilisé des quantités de $NH_3$ différentes, avec des débits respectifs de 4,5 ; 10 et 15 $cm^3$/min.

Le pourcentage d'aluminium des couches séparées en fonction du débit d'ammoniac a été déterminé par EDS et est indiqué dans le tableau I.

Tableau I

| EXEMPLE | Débit d'ammoniac ($cm^3$/min) | Pourcentage en aluminium |
|---------|-------------------------------|--------------------------|
| 1 | 3 | 0 |
| 2 | 4,5 | 45 |

Tableau I   (suite)

| EXEMPLE | Débit d'ammoniac (cm$^3$/min) | Pourcentage en aluminium |
|---------|------------------------------|--------------------------|
| 3 | 5 | 52 |
| 4 | 10 | 58 |
| 5 | 15 | 60 |

Le tableau I démontre clairement que :

- l'augmentation de la quantité de NH$_3$ permet d'accroître la proportion d'aluminium par rapport au titane dans le dépôt.

Ainsi, pour des débits d'ammoniac variant de 3 à 15 cm$^3$/min, le pourcentage d'aluminium fluctue de 0 à 60 %.

Exemple 6

Cet exemple illustre la préparation d'un revêtement multicouche selon l'invention sur un substrat en acier ou encore acier inox ou silicium.

Le dispositif mis en oeuvre pour le dépôt est sensiblement analogue à celui représenté sur la figure 1.

Un pilotage informatique des débits gazeux et en particulier un contrôle précis du débit de NH$_3$ permet de réaliser un empilement de couches successives de (Ti,Al)N à composition variable et/ou de TiN.

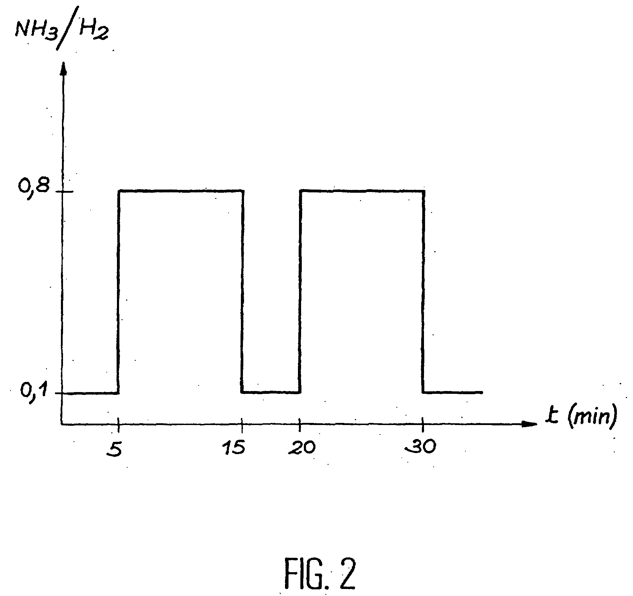

La séquence de réalisation d'un tel revêtement est représenté sur la figure 2 qui est un graphique où a été porté en abscisses le temps en minutes, et en ordonnées le rapport molaire NH$_3$/H$_2$.

Dans la première phase du dépôt d'une durée de cinq minutes, le rapport molaire NH$_3$/H$_2$ est fixé à 0,1 et l'on obtient une couche de TiN pur d'une épaisseur de 0,2 µm puis dans la deuxième phase, la charge ou cible ou source restant identique, on augmente rapidement le débit d'ammoniac, pour avoir un rapport molaire de NH$_3$/H$_2$ de 0,8 qui est maintenu pendant une durée de 10 minutes, et l'on dépose ainsi une couche de (Ti,Al)N d'un'e épaisseur de 0,5 µm dont le pourcentage d'aluminium est d'environ 60%.

A l'issue de cette phase, au temps t = 15 minutes, on diminue rapidement le débit d'ammoniac afin d'avoir un rapport molaire NH$_3$/H$_2$ de nouveau égal à 0,1, et l'on dépose alors, dans une troisième phase et pendant une durée de 5 minutes, une couche de TiN pur d'une épaisseur 0,2 µm.

On effectue ensuite dans une quatrième et cinquième phases des dépôts de (Ti,Al)N, puis de TiN de la même manière que pour les couches précédemment déposées.

On constate que tout le dépôt de ce revêtement complexe à plusieurs couches est fait sans arrêt en un temps relativement court.

Le revêtement ainsi déposé sur le substrat présente d'excellentes propriétés par exemple un bon comportement dans des applications d'anti-usure de résistance à l'oxydation ou à la corrosion ou encore une bonne dureté.

**Revendications**

1. Procédé de préparation d'un revêtement multicouche comprenant un empilement sur un substrat de plusieurs couches choisies parmi les couches constituées de nitrure de titane TiN et les couches constituées de nitrure de titane aluminium (Ti,Al)N ou Ti$_{1-x}$Al$_x$N, **caractérisé en ce que** ledit revêtement est déposé en continu et en une seule opération, par dépôt chimique en phase vapeur thermique (CVD thermique), à partir d'un mélange gazeux réducteur comprenant de l'ammoniac, de l'hydrogène, et en tant que précurseurs des chlorures de titane et éventuellement d'aluminium, préparés in-situ par chloruration d'une charge ou cible unique d'alliage de titane et d'aluminium, la nature et/ou la composition de chaque couche déposée étant ajustée(s) instantanément au cours de l'opération de dépôt en modifiant le rapport molaire gaz réducteur sur hydrogène dans le mélange gazeux.

2. Procédé selon la revendication 1, **caractérisé en ce que** le rapport molaire gaz réducteur sur hydrogène dans le mélange gazeux est de 0,01 à 1.

3. Procédé selon l'une quelconque des revendications 1 et 2, **caractérisé en ce que** le mélange gazeux comprend en outre un gaz vecteur choisi parmi l'argon, l'hélium et leurs mélanges.

**4.** Procédé selon l'une quelconque des revendications 1 à 3, **caractérisé en ce que** le procédé est réalisé à une pression de $10^2$ à $10^5$ Pa.

**5.** Procédé selon la revendication 1, **caractérisé en ce que** les chlorures de titane et d'aluminium sont $AlCl_3$ et $TiCl_3$.

**6.** Procédé selon l'une quelconque des revendications 1 à 5, **caractérisé en ce que** le substrat à revêtir est porté à une température de 700 à 1400 K.

**7.** Procédé selon l'une quelconque des revendications 1 à 6, **caractérisé en ce que** la proportion d'aluminium dans le nitrure de titane aluminium varie de 0 à 60 %.

**8.** Procédé selon l'une quelconque des revendications 1 à 7, **caractérisé en ce que** le revêtement multicouche comprend de 2 à 1000 couches.

**9.** Procédé selon l'une quelconque des revendications 1 à 8, **caractérisé en ce que** chaque couche à une épaisseur de 0,02 à 0,5 μm.

**10.** Procédé selon l'une quelconque des revendications 1 à 9, **caractérisé en ce que** le revêtement a une épaisseur totale de 1 à 50 μm.

**11.** Procédé selon l'une quelconque des revendications 1 à 10, **caractérisé en ce que** préalablement ou consécutivement à l'opération de dépôt, on effectue en outre un traitement thermochimique dans la même enceinte.

**12.** Procédé selon la revendication 11, **caractérisé en ce que** ledit traitement thermochimique est choisi parmi les nitrurations thermiques ou chimiques et les carburations.

**Claims**

**1.** Process for the preparation of a multilayer coating, comprising a stack, on a substrate, of several layers chosen from among layers constituted by titanium nitride TiN and layers constituted by aluminium titanium nitride $Ti_{1-x}Al_xN$ (or (Ti,Al)N), **characterized in that** said coating is deposited continuously and in a single operation by thermal chemical vapour deposition (thermal CVD) from a gaseous reducing mixture comprising ammonia, hydrogen and as precursors, titanium and optionally aluminium chlorides prepared in situ by chlorination from a single target or charge of titanium and aluminium alloy, the nature and/or composition of each deposited layer being instantaneously adjusted during the deposition operation by modifying the reducing gas to hydrogen molar ratio in the gaseous mixture.

**2.** Process according to claim 1, **characterized in that** the reducing gas to hydrogen molar ratio in the gaseous mixture is 0.01 to 1.

**3.** Process according to either of the claims 1 and 2, **characterized in that** the gaseous mixture also incorporates a vector gas chosen from among argon, helium and mixtures thereof.

**4.** Process according to any one of the claims 1 to 3, **characterized in that** the process is performed at a pressure of $10^2$ to $10^5$ Pa.

**5.** Process according to claim 1, **characterized in that** the titanium and aluminium chlorides are $AlCl_3$ and $TiCl_3$.

**6.** Process according to any one of the claims 1 to 5, **characterized in that** the substrate to be coated is raised to a temperature of 700 to 1400 K.

**7.** Process according to any one of the claims 1 to 6, **characterized in that** the aluminium proportion in the aluminium titanium nitride varies from 0 to 60%.

**8.** Process according to any one of the claims 1 to 7, **characterized in that** the multilayer coating has 2 to 1000 layers.

**9.** Process according to any one of the claims 1 to 8, **characterized in that** each layer has a thickness of 0.02 to 0.5

μm.

10. Process according to any one of the claims 1 to 9, **characterized in that** the coating has a total thickness of 1 to 50 μm.

11. Process according to any one of the claims 1 to 10, **characterized in that** prior to or following the deposition operation, a thermochemical treatment takes place in the same enclosure.

12. Process according to claim 11, **characterized in that** said thermochemical treatment is chosen from among thermal or chemical nitriding and carburizing.


**Patentansprüche**

1. Verfahren zur Herstellung einer mehrlagigen Beschichtung eines Substrats mit einem Stapel aus mehreren Lagen, gebildet durch Lagen aus Titannitrid TiN und Titanaluminiumnitrid (Ti,Al)N oder $Ti_{1-x}Al_xN$,
   **dadurch gekennzeichnet,**
   **dass** die genannte Beschichtung kontinuierlich und in einer einzigen Operation abgeschieden wird mittels thermischer chemischer Gasphasenabscheidung (thermische CVD) aus einem reduzierenden Gasgemisch, das Ammoniak, Wasserstoff und als Zwischenstoffe Titan- und eventuell Aluminiumchloride umfasst, in situ hergestellt durch Chlorierung eines einzigen Einsatzes oder Targets aus Titan- und Aluminiumlegierung, wobei die Art und/oder die Zusammensetzung jeder abgeschiedenen Schicht während der Abscheidoperation momentan angepasst wird, indem man in dem Gasgemisch das Molverhältnis Reduziergas zu Wasserstoff modifiziert.

2. Verfahren nach Anspruch 1, **dadurch gekennzeichnet, dass** das Molverhältnis Reduziergas zu Wasserstoff in dem Gasgemisch 0,01 bis 1 beträgt.

3. Verfahren nach einem der Ansprüche 1 und 2, **dadurch gekennzeichnet, dass** das Gasgemisch außerdem ein Vektorgas umfasst, ausgewählt zwischen Argon, Helium und ihren Gemischen.

4. Verfahren nach einem der Ansprüche 1 bis 3, **dadurch gekennzeichnet, dass** das Verfahren bei einem Druck von $10^2$ bis $10^5$ Pa durchgeführt wird.

5. Verfahren nach Anspruch 1, **dadurch gekennzeichnet, dass** die Titan- und Aluminiumchloride $AlCl_3$ und $TiCl_3$ sind.

6. Verfahren nach einem der Ansprüche 1 bis 5, **dadurch gekennzeichnet, dass** das zu beschichtende Substrat auf eine Temperatur von 700 bis 1400 K gebracht wird.

7. Verfahren nach einem der Ansprüche 1 bis 6, **dadurch gekennzeichnet, dass** der Aluminiumanteil in dem Titanaluminiumnitrid von 0 bis 60% variiert.

8. Verfahren nach einem der Ansprüche 1 bis 7, **dadurch gekennzeichnet, dass** die mehrlagige Beschichtung 2 bis 1000 Lagen umfasst.

9. Verfahren nach einem der Ansprüche 1 bis 8, **dadurch gekennzeichnet, dass** jede Lage eine Dicke von 0,02 bis 0,5 μm hat.

10. Verfahren nach einem der Ansprüche 1 bis 9, **dadurch gekennzeichnet, dass** die Beschichtung eine Gesamtdicke von 1 bis 50 μm hat.

11. Verfahren nach einem der Ansprüche 1 bis 10, **dadurch gekennzeichnet, dass** man vor oder nach der Abscheidoperation in demselben Behälter außerdem eine thermochemische Behandlung durchführt.

12. Verfahren nach Anspruch 11, **dadurch gekennzeichnet, dass** die genannte thermochemische Behandlung ausgewählt wird unter den thermischen oder chemischen Nitrierungen und den Carburierungen.

FIG.1

FIG. 2